# FASCICULE DE BREVET EUROPEEN

(11) **EP 3 043 396 B1**
(45) Date de publication et mention de la délivrance du brevet: **06.06.2018**
(21) Numéro de dépôt: 16150341.2
(22) Date de dépôt: 06.01.2016
(51) Int. Cl.: H01L 45/00

(54) **CELLULE MÉMOIRE NON VOLATILE RÉSISTIVE ET SON PROCÉDÉ DE FABRICATION**
RESISTIVE NICHT FLÜCHTIGE SPEICHERZELLE, UND IHR HERSTELLUNGSVERFAHREN
RESISTIVE NON-VOLATILE MEMORY CELL AND METHOD FOR MANUFACTURING SAME

(30) Priorité: 06.01.2015 FR 1550049
(43) Date de publication de la demande: 13.07.2016
(73) Titulaire: Commissariat à l'Energie Atomique et aux Energies Alternatives, 75015 Paris (FR)
(72) Inventeur: GASSILLOUD, Rémy, 38380 SAINT-LAURENT-DU-PONT (FR); BERNARD, Mathieu, 38950 SAINT MARTIN LE VINOUX (FR)
(74) Mandataire: Brizio Delaporte, Allison

(56) Documents cités:
- US-A1- 2012 032 132
- US-A1- 2013 146 829

## Description

### DOMAINE TECHNIQUE

La présente invention concerne en général les mémoires non volatiles à éléments résistifs. Elle décrit plus particulièrement une cellule mémoire non volatile résistive et son procédé de fabrication.

L'invention trouvera son application possiblement dans toutes les applications déjà couvertes par les mémoires non volatiles existantes ; notamment, les mémoires de type Flash. En raison de leur temps d'accès et de leur facilité d'écriture, les mémoires non volatiles à éléments résistifs peuvent aussi remplacer les mémoires traditionnelles statiques ou SRAM, de l'anglais « static random access memory ».

L'invention trouvera également son application pour la réalisation de structures mémoires de type neuro-morphique ou pour des mémoires CBRAM pour l'acronyme anglais « Conductive Bridge Ramdom Access Memory » ou encore dans des dispositifs nanoélectroniques basés sur le principe de transitions Métal/Isolant aussi appelés « Mott insulator », tel que par exemple les sélecteurs de Mott, les transistors de Mott, les dispositifs incluant des transitions de Mott photo-induites.

### ETAT DE LA TECHNIQUE

Les mémoires à éléments résistifs utilisent un matériau qui peut basculer réversiblement entre au moins deux états stables présentant des résistances électriques différentes.

Les mémoires résistives sont globalement désignées sous le nom de RRAM, acronyme de l'anglais « resistive random access memory », c'est-à-dire : « mémoire résistive à accès aléatoire ».

Parmi les différents types de mémoires résistives existantes celles dont le matériau de base est un diélectrique, normalement isolant, sont plus particulièrement considérées. Ces mémoires désignées par le terme OxRAM utilisent des oxydes métalliques (Ox) comme matériau diélectrique dont la résistance peut être contrôlée d'une manière réversible.

Ces mémoires mettent en oeuvre un mode de fonctionnement dans lequel au moins un filament conducteur peut être formé entre deux électrodes séparées par l'oxyde après application d'une tension suffisamment importante entre celles-ci. Une fois que le filament a été formé, un état à faible résistance, généralement qualifié de LRS, de l'anglais « low résistance state », est obtenu. Cet état peut être inversé par une opération dite de « RESET », afin de mettre la mémoire dans un second état à forte résistance ou HRS de l'anglais « high résistance state », opération au cours de laquelle le ou les filaments sont rompus. Une fois que le filament a été formé une première fois une opération dite de « SET » peut remettre à nouveau la mémoire dans un état à faible résistance ou LRS en reformant au moins un filament.

On connait de In situ observation of filamentary conducting channels in an asymmetric Ta2O5-x/TaO2-x bilayer structure Gyeong-Su Park, Nature Communications 4, (2013) 2382, un empilement MIM dont la couche mémoire est composée d'un oxyde métallique à base de Tantale, en monocouche ou en bicouche TaOx/Ta2O5. Le film de TaOx, sous-stoechiométrique en oxygène et réservoir de lacunes, fournit les lacunes nécessaires à la formation du filament conducteur dans le Ta2O5 permettant de moduler la résistance de ce dernier.

Ces structures de mémoires non volatiles résistives ont un réservoir de lacunes d'oxygène localisé au contact des électrodes. Ceci impose d'utiliser des électrodes insensibles aux mouvements d'oxygène/lacunes notamment par des électrodes en matériaux nobles. Or, l'utilisation d'électrodes à caractère noble limite fortement l'utilisation d'un tel empilement dans une intégration au standard de la microélectronique où seulement un certain nombre de métaux, n'incluant pas les métaux nobles, ont montrés leurs immunités vis-vis du fonctionnement d'un transistor.

Par ailleurs, il s'est avéré que l'utilisation d'une électrode non noble conduit souvent à une augmentation de la variabilité d'un dispositif à l'autre ainsi qu'à une faible fiabilité de la cellule mémoire en termes de cyclage et de rétention en fonction temps.

La présente invention a pour but de répondre à certaines au moins de ces problématiques.

### RÉSUMÉ DE L'INVENTION

La présente invention propose à cet effet une cellule mémoire non volatile résistive comprenant un empilement de type Métal-Isolant-Métal avec une électrode inférieure et une électrode supérieure et dans lequel l'isolant est un multicouche comprenant une couche d'oxyde métallique stoechiométrique et une couche d'oxyde métallique sous stoechiométrique formant une couche de réservoir de lacunes d'oxygène et dans lequel la couche métallique formant l'électrode supérieure comprend une couche d'oxyde métallique stoechiométrique en dessous de ladite couche métallique. Cette disposition permet de placer la couche de réservoir de lacunes d'oxygène entre deux couches d'oxyde métallique stoechiométrique supprimant le contact entre ladite couche de réservoir de lacunes et les électrodes. De cette manière la quantité de lacunes d'oxygène dans le réservoir est stable au cours du temps et du cyclage de la mémoire. Avantageusement, la sélection des matériaux pour les électrodes s'étendent en dehors des métaux nobles ce qui permet une intégration de la cellule mémoire selon l'invention au standard de la microélectronique dans un transistor.

Pa ailleurs, dans le cadre du développement de la présente invention, il s'est avéré qu'un contact entre un réservoir de lacunes d'oxygène et une électrode non noble peut induire une variation de la quantité d'oxygène dans le réservoir de lacunes d'oxygène en fonction du temps ou au cours du cyclage de la cellule mémoire pouvant résulter en une augmentation de la variabilité d'un dispositif à l'autre.

L'invention permet ainsi de répondre à ce problème. Elle permet également d'améliorer la fiabilité des cellules mémoire en termes de cyclage et de rétention en fonction temps.

Avantageusement, les électrodes sont des métaux non nobles.

Avantageusement, les métaux M1 de l'électrode inférieure, M2 de l'isolant multicouche et M3 de la couche d'oxyde métallique stoechiométrique sont choisis de sorte à ce que le métal M3 réduise l'oxyde métallique stoechiométrique I2 de l'isolant mais pas un oxyde métallique stoechiométrique I1 potentiellement présent à la surface de la couche métallique formant l'électrode inférieure.

Avantageusement, l'enthalpie libre de formation DG3 de l'oxyde métallique stoechiométrique I3 par oxydation d'un métal M3 est supérieure en valeur absolue à l'enthalpie libre de formation DG2 de l'oxyde métallique stoechiométrique I2 par oxydation d'un métal M2.

Avantageusement, l'enthalpie libre de formation DG1 de l'oxyde métallique stoechiométrique I1 par oxydation d'un métal M1 est supérieure ou égale en valeur absolue à l'enthalpie libre de formation DG3 de l'oxyde métallique stoechiométrique I3 par oxydation d'un métal M3.

Selon un autre aspect, l'invention concerne un procédé de fabrication d'une cellule mémoire selon l'une quelconque des revendications précédentes comprenant les étapes successives suivantes de dépôt d'une couche métallique M1 pour former l' électrode inférieure, de dépôt d'une couche d'oxyde métallique I2, de dépôt d'une couche métallique M3, de réaction de la couche métallique M3 avec l'oxyde métallique stoechiométrique I2 formant un oxyde sous stoechiométrique I2p et un oxyde métallique I3, de dépôt d'une couche métallique M4.

Selon un autre aspect, l'invention concerne un dispositif microélectronique caractérisé en ce qu'il comprend une cellule mémoire telle que décrite ci-dessus.

Avantageusement, le dispositif comprend une cavité dans laquelle est au moins partiellement agencée la cellule mémoire. Selon un mode de réalisation la cellule mémoire est entièrement comprise dans la cavité.

Cette disposition permet par effet de confinement de s'affranchir de l'impact de l'oxygène exogène apporté par les étapes successives lors de la fabrication d'un tel dispositif et notamment lors du dépôt d'oxyde d'interconnexion. Cela permet d'envisager de localiser le filament dans une région bien définie et préférentiellement centrée de l'empilement ce qui entraine une réduction du potentiel de formation du filament Vf par constriction des lignes de courant traversant l'empilement. Cette intégration permet aussi une réduction de la variabilité de l'état passant du dispositif.

Selon un autre aspect, l'invention concerne un procédé de fabrication d'un dispositif tel que décrit ci-dessus comprenant les étapes successives suivantes :
- Dépôt conforme d'une couche d'oxyde métallique stoechiométrique I2 dans la cavité ;
- Dépôt d'une couche métallique M3 dans la cavité ;
- Réaction de la couche métallique M3 avec l'oxyde métallique stoechiométrique I2 formant un oxyde sous stoechiométrique I2p et un oxyde métallique stoechiométrique I3 ;
- Dépôt d'au moins une couche métallique M4 dans la cavité.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les figures d'accompagnement dans lesquelles :
Figure 1 : Schéma d'une cellule mémoire selon l'invention.
Figure 2 : Courbe illustrant le profil en oxygène dans chacune des couches de l'empilement d'une cellule mémoire selon l'invention.
Figures 3 à 9 : représentent une cellule mémoire selon l'invention agencée au moins partiellement dans une cavité d'un dispositif microélectronique.

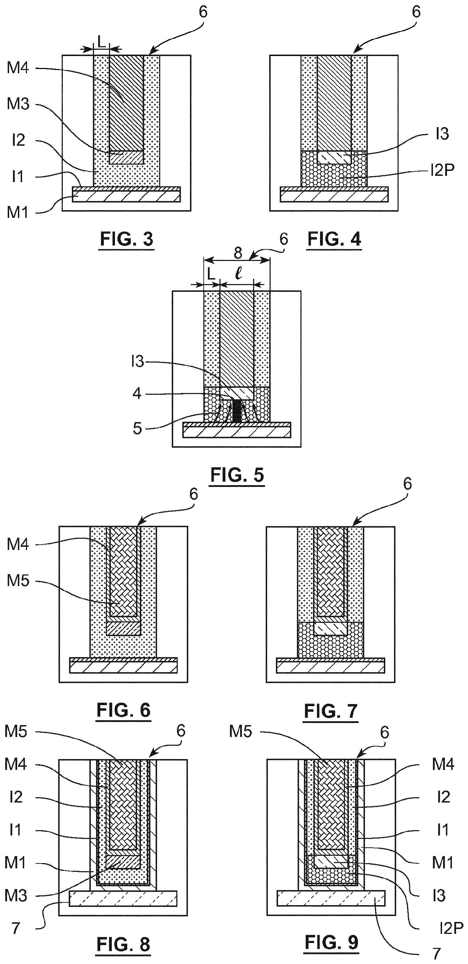

Figure 3 : représente la cellule mémoire selon un premier mode de réalisation partiellement agencée dans la cavité avant la réaction de la couche métallique M3 sur la couche d'oxyde métallique stoechiométrique I2.
Figure 4 : représente la cellule mémoire de la figure 3, la couche métallique M3 ayant réagi sur la couche d'oxyde métallique stoechiométrique I2 pour former la couche d'oxyde métallique stoechiométrique I3 et la couche d"oxyde métallique sous stoechiométrique I2p.
Figure 5 : représente la cellule mémoire de la figure 4 lors de la formation du filament et des lignes de courant.
Figures 6 et 7 : représentent la cellule mémoire partiellement agencée dans une cavité selon un deuxième mode de réalisation avant et après réaction de la couche métallique M3 sur la couche d'oxyde métallique stoechiométrique I2.
Figures 8 et 9 : représentent la cellule mémoire selon un troisième mode de réalisation où l'élément mémoire est entièrement agencé dans une cavité d'un dispositif microélectronique.

Les dessins joints sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement.

On rappelle tout d'abord que l'invention porte sur une cellule mémoire non volatile résistive comprenant un empilement comprenant deux électrodes et un isolant multi-couche, placé entre lesdites deux électrodes, comprenant une couche d'oxyde permettant une transition résistive et une couche de réservoir de lacunes d'oxygène caractérisée en ce que l'empilement comprend de bas en haut :
- une électrode inférieure comprenant une couche métallique M1,
- un isolant comprenant une couche d'oxyde métallique stoechiométrique I2 et une couche d'oxyde métallique sous stoechiométrique I2p formant ladite couche de réservoir de lacunes d'oxygène
- une électrode supérieure comprenant une couche d'oxyde métallique stoechiométrique I3 et une couche métallique M4, de sorte que la couche de réservoir de lacunes d'oxygène est intercalée entre deux couches d'oxydes métalliques stoechiométriques I2 et I3.

Avantageusement, des métaux M2 et M3 respectivement pour former l'isolant I2 et I2p et pour former la couche d'oxyde métallique stoechiométrique I3 sont choisis de sorte que l'enthalpie libre de formation DG3 de l'oxyde métallique stoechiométrique I3 par oxydation du métal M3 est supérieure en valeur absolue à l'enthalpie libre de formation DG2 de l'oxyde métallique stoechiométrique I2 par oxydation du métal M2.

Avantageusement, l'électrode inférieure comprend au-dessus de la couche métallique M1, une couche I1 d'oxyde métallique de M1.

Avantageusement, les métaux M1 et M3 sont choisis de sorte que l'enthalpie libre de formation DG1 de l'oxyde I1 par oxydation d'un métal M1 est supérieure ou égale en valeur absolue à l'enthalpie libre de formation DG3 de l'oxyde I3 par oxydation d'un métal M3.

Avantageusement, le métal M1 est choisi de sorte que l'enthalpie libre de formation DG1 de l'oxyde I1 par oxydation d'un métal M1 est supérieure ou égale en valeur absolue à l'enthalpie libre de formation DG de la réaction 2Cu + O2 -> 2CuO.

Avantageusement, les métaux M1 et M4 sont choisis parmi un métal non-noble autre que Pd, Ag, Ir, Pt, Au, ou un métal pure ou un alliage métallique binaire ou ternaire, ou un alliage à base de nitrure ou de carbure ou de siliciure ou d'oxyde métallique conducteur.

Avantageusement, les métaux M1 et M4 sont choisis parmi TiN, TaN, TiAlN, TaAlN.

Avantageusement, l'électrode inférieure et l'électrode supérieure sont symétriques dans l'empilement.

Avantageusement, la couche I1 d'oxyde métallique stoechiométrique de M1 est choisie parmi TiO2 ou TiON ou Al2O3.

Avantageusement, la couche d'oxyde stoechiométrique I2 est formée à partir d'un métal M2 choisi parmi des colonnes III, IV, V, du tableau périodique, ou Al ou Si, ou des lanthanides.

Avantageusement, la couche d'oxyde stoechiométrique I2 est choisie parmi HfO2, ZrO2, TiO2, Al2O3, Ta2O5, Nb2O5, V2O5, La2O4, Gd2O3, Lu2O3, HfSiO, HfZrO, STO.

Avantageusement, la couche d'oxyde stoechiométrique I2 d'un métal M2 présente une épaisseur de 1 à 50nm.

Avantageusement, la couche d'oxyde métallique I3 est formée à partir d'un métal M3 choisi parmi, un métal pur ou un alliage métallique binaire ou ternaire.

Avantageusement, le métal M3 est choisi parmi Si, Ti, Zr, Hf, Al, Ta, Nb, V, et les alliages en mélange de ces éléments, par exemple TiAl, TaAl.

Avantageusement, l'empilement comprend de bas en haut : TiN/TiO2/Ta2O5/TaOx/TiO2/TiN, ou TiN/TiO2/Ta2O5/TaOx/Nb2O5/TiN, ou TiN/TiO2/V2O5/VOx/Nb2O5/TiN, ou TiN/TiO2/V2O51VOx/Ta2O5/TiN

Un autre objet de l'invention est un procédé de fabrication d'une cellule mémoire telle que décrites précédemment comprenant les étapes successives suivantes :
- Dépôt d'une couche métallique M1 pour former l'électrode inférieure,
- Dépôt d'une couche d'oxyde métallique stoechiométrique I2,
- Dépôt d'une couche métallique M3,
- Réaction de la couche métallique M3 avec l'oxyde métallique I2 formant un oxyde sous stoechiométrique I2p et un oxyde métallique stoechiométrique I3,
- Dépôt d'une couche métallique M4.

Avantageusement, le dépôt de la couche métallique M3 est réalisé par dépôt flash en phase vapeur. Avantageusement, le dépôt de la couche métallique M3 n'est pas un dépôt conforme. Cela permet notamment de simplifier la réalisation.

Avantageusement et optionnellement, la couche métallique M3 est déposée sur une épaisseur de 0,1 à 2nm.

Avantageusement, la couche d'oxyde I2 métallique stoechiométrique est déposée par voie chimique.

Avantageusement, la couche d'oxyde métallique stoechiométrique I2 est traitée au plasma ou par nitruration plasma.

Avantageusement, la couche d'oxyde métallique stoechiométrique I2 est implantée d'aluminium.

Un autre objet de l'invention est un dispositif microélectronique caractérisé en ce qu'il comprend une cellule mémoire telle que décrite ci-dessus.

Avantageusement, le dispositif comprend une cavité dans laquelle est au moins partiellement agencée la cellule mémoire. La cavité est formée dans un matériau électriquement isolant, tel qu'un oxyde.

Avantageusement, l'électrode inférieure de la cellule mémoire est agencée en dessous et en dehors de la cavité.

Avantageusement, l'électrode inférieure de la cellule mémoire est agencée dans la cavité.

Avantageusement, le dispositif comprend une pluralité de niveau d'interconnexion et une pluralité de plug de connexion entre les niveaux, chaque plug comprenant une cavité dans laquelle est au moins partiellement agencée une cellule mémoire telle que décrite ci-dessus.

Un autre objet de l'invention est un procédé de fabrication d'un dispositif tel que décrit ci-dessus comprenant les étapes successives suivantes :
- Dépôt conforme d'une couche d'oxyde métallique stoechiométrique I2 dans la cavité,
- Dépôt d'une couche métallique M3 dans la cavité, de préférence par dépôt flash en phase vapeur. Ce dépôt de la couche métallique M3 est effectué sur la couche d'oxyde métallique stoechiométrique I2, de préférence dans le fond de la cavité de manière à ce qu'une portion des ou de la parois de la couche d'oxyde métallique stoechiométrique I2 ne soit pas recouverte par la couche métallique M3. ;
- Réaction de la couche métallique M3 avec l'oxyde métallique stoechiométrique I2 formant un oxyde sous stoechiométrique I2p et un oxyde métallique stoechiométrique I3,
- Dépôt d'au moins une couche métallique M4 dans la cavité. Ce dépôt de la couche métallique M4 est effectué sur l'oxyde métallique stoechiométrique I3 et sur la ou les parois verticales de la couche d'oxyde métallique stoechiométrique I2.

Avantageusement, le procédé comprend le dépôt conforme d'une couche métallique M1 dans la cavité pour former l'électrode inférieure avant le dépôt de la couche d'oxyde métallique stoechiométrique I2.

Avantageusement, le procédé comprend le dépôt d'une couche métallique M5 pour boucher la cavité.

Avantageusement, le dépôt de la couche métallique M3 est réalisé par dépôt flash en phase vapeur.

Avantageusement, la couche métallique M3 est déposée sur une épaisseur de 0,1 à 2nm.

Avantageusement, la couche d'oxyde métallique stoechiométrique I2 est déposée par voie chimique.

Avantageusement, la couche d'oxyde métallique stoechiométrique I2 est traitée au plasma ou par nitruration plasma.

Avantageusement, la couche d'oxyde métallique stoechiométrique I2 est implantée d'aluminium.

On notera que les caractéristiques relatives énoncées ci-dessus, notamment celles relatives à l'empilement de la cellule mémoire et à l'agencement de la cellule mémoire dans la cavité, bien qu'oeuvrant avantageusement en synergie lorsqu'elles sont combinées, peuvent être exploitées indépendamment les unes des autres et conférer néanmoins alors certains avantages techniques.

Il est précisé que dans le cadre de la présente invention, le terme « sur », « surmonte » ou « sous-jacent » ou leurs équivalents ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

On entend les termes « couche » et « film » comme des synonymes.

On entend par « couche mince », une couche dont l'épaisseur varie de quelques couches atomiques à quelques micromètres.

Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

La cellule mémoire selon l'invention est un empilement de couches de type Métal-Isolant-Métal (MIM) plus spécifiquement de type Métal-Oxyde-Métal (MOM). La cellule mémoire est une mémoire non volatile à changement de résistance. Les mémoires résistives (RRAM pour Resistive Random Access Memory) reposent sur le changement de résistance d'un matériau actif, plus précisément dans la sous-catégorie des OxRRAM (Oxyde RRAM) le matériau actif est un oxyde formant un isolant 2. Les deux couches métalliques de part et d'autres de l'isolant 2 sont des électrodes 1, 3.

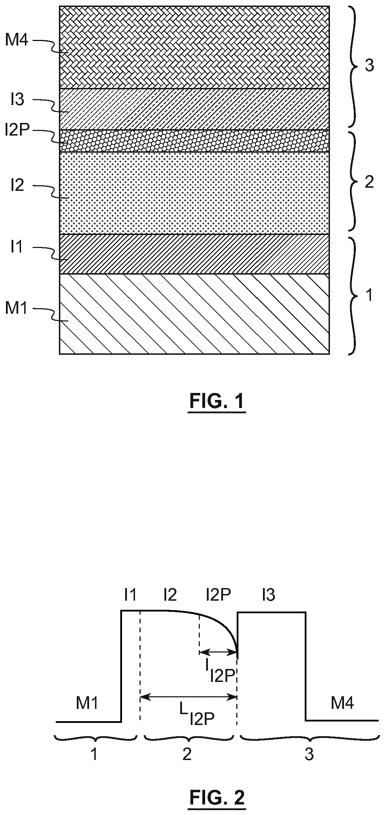

L'empilement selon un mode de réalisation préféré de l'invention est représenté à la figure 1. L'empilement comprend de bas en haut: une couche métallique M1, éventuellement une couche d'oxyde métallique I1, une couche d'oxyde métallique stoechiométrique I2, une couche d'oxyde métallique sous stoechiométrique I2p, une couche d'oxyde métallique stoechiométrique I3 et une couche métallique M4.

Une électrode inférieure 1 également appelée « bottom electrode » en anglais comprend la couche métallique M1 et par-dessus potentiellement une couche d'oxyde métallique I1.

La couche métallique M1 est formée par un métal non noble. On entend par noble, un métal qui ne s'oxyde pas spontanément à l'air. Selon l'invention, les métaux nobles s'entendent de l'argent (Ag), de l'Iridium (Ir), du Platine (Pt), de l'or (Au) et du palladium (Pd). La couche métallique M1 peut-être un métal pure ou un alliage métallique binaire ou ternaire tel que par exemple TiAl, TaAl, TiAlN, TaAlN ou bien encore ou un alliage à base de nitrure, ou de carbure, ou de siliciure, ou d'oxyde métallique conducteur, préférentiellement TiN, TaN.

L'oxyde métallique I1 est un oxyde qui peut se former lors du procédé de fabrication de la cellule mémoire. Le métal de la couche métallique M1 peut être oxydé par l'air en contact, ou bien par un oxyde métallique stoechiométrique I2 décrit ci-après. Selon une autre possibilité, la couche métallique M1 peut aussi être intentionnellement oxydée pour former l'oxyde métallique I1. Selon encore une autre possibilité, l'oxyde métallique I1 est déposé, par exemple pour former un sélecteur ou une diode résistance non-linéaire. .A titre d'exemple l'oxyde métallique I1 est du TiO2 ou du TiON.

Un isolant 2 comprend avantageusement au moins deux couches de matériaux également appelé un multicouche, l'isolant 2 est préférentiellement une bi-couche. La bi-couche comprend une couche d'oxyde métallique stoechiométrique I2 et une couche d'oxyde métallique sous stoechiométrique I2p.

Le terme stoechiométrique s'entend comme la proportion des éléments dans une formule brute. Une couche sous stoechiométrique selon l'invention présente une proportion d'oxygène inférieure à la proportion stoechiométrique du composé.

L'oxyde métallique stoechiométrique I2 constitue la couche active présentant une variation résistive en fonction d'une tension appliquée. L'oxyde métallique sous stoechiométrique I2p constitue quant à lui une couche réservoir de lacunes d'oxygènes. Cette couche est un oxyde présentant une quantité d'oxygène moindre que l'oxyde stoechiométrique. Ce défaut d'oxygène est défini comme des lacunes en oxygène. Plus un matériau présente des lacunes d'oxygène, plus il est conducteur. Cette couche I2p de réserve de lacunes d'oxygène permet de faciliter les variations de résistivité de la couche d'oxyde I2. En effet, les deux couches I2 et I2p interagissent lors des phases de SET et de RESET de sorte permettre la formation des filaments conducteurs entre les deux électrodes 1 et 3.

La couche d'oxyde métallique stoechiométrique I2 est avantageusement une couche mince.

L'oxyde métallique stoechiométrique I2 est un oxyde stoechiométrique métallique. Cet oxyde I2 est choisi parmi des colonnes III, IV, V, du tableau périodique, ou Aluminium (Al) ou Silicium (Si), ou un lanthanide, à titre d'exemple HfO2, ZrO2, TiO2, Al2O3, Ta2O5, Nb2O5, La2O4, Gd2O3, Lu2O3, ou des composés ternaires HfSiO, HfZrO, STO. L'oxyde métallique stoechiométrique I2 est préférentiellement du Ta2O5. Préférentiellement, la couche d'oxyde métallique stoechiométrique I2 est déposée par voie chimique. Avantageusement son épaisseur est comprise entre 1nm et 50nm. Selon une possibilité, l'oxyde métallique stoechiométrique I2 est traité au plasma. Ce type de traitement permet de moduler l'épaisseur finale L et/ou le profil de déplétion en oxygène de la couche d'oxyde métallique sous stoechiométrique I2p. A titre d'exemple, des traitements de type nitruration plasma (plasma Radio-fréquence ou Micro-onde N2) à l'azote ou nitruration sous atmosphère réductrice typiquement en atmosphère hydrogénée N2+ H2.
Selon une autre possibilité, la couche d'oxyde métallique stoechiométrique I2 est traitée par implantation. L'implantation peut être faite directement dans la couche I2 ou bien à travers la couche d'oxyde métallique stoechiométrique I3 et la couche d'oxyde métallique sous stoechiométrique I2p. Ce traitement par implantation permet de favoriser la formation de filaments conducteurs entre l'électrode inférieure 1 et l'électrode supérieure 3 de l'empilement de la cellule mémoire. A titre d'exemple, une implantation d'aluminium peut être réalisée.

L'oxyde métallique I2p est un oxyde sous stoechiométrique. Cet oxyde I2p n'est pas volontairement déposé mais est issu d'une réaction avec un métal M3 déposé au-dessus de l'oxyde métallique stoechiométrique I2.

Le métal M3 est préférentiellement un métal pur ou un alliage métallique binaire ou ternaire, par exemple, TiAl, TaAl, préférentiellement du Titane (Ti) pur.

Selon un mode de réalisation préféré, le métal M3 est déposé par dépôt flash en phase vapeur (flash PVD en anglais). Le terme de « flash » correspond au contrôle sur un temps très court, avantageusement de l'ordre de la seconde, du dépôt d'un film de quelques Angstroem. Préférentiellement, la couche métallique M3 déposée est d'une épaisseur de 0,1nm à 2nm. Le contrôle de ce temps permet très avantageusement de déposer très précisément la quantité de métal M3 voulue afin de pouvoir moduler la profondeur de déplétion en oxygène dans la couche d'oxyde métallique stoechiométrique I2 et l'épaisseur finale L de la couche d'oxyde métallique sous stoechiométrique I2p.

Le temps de flash va permettre de définir l'épaisseur finale de l'oxyde métallique stoechiométrique I3. Le type de dépôt du métal M3 influence la résistivité globale de la cellule mémoire. Selon un mode de réalisation, le dépôt flash permet de former des ilots localisés, appelés aussi dots, nanodots ou nanocristaux, permettant de réduire localement la couche d'oxyde métallique stoechiométrique I2, et ainsi permettre de localiser les filaments conducteurs 4 dans la couche d'oxyde métallique stoechiométrique I2.

Le métal M3 déposé n'est plus présent sous forme de métal dans la cellule mémoire finalisée. Le métal M3 est configuré pour réagir avec la couche d'oxyde métallique stoechiométrique I2. Cette réaction conduit à une réduction partielle de l'oxyde métallique stoechiométrique I2 en un oxyde métallique sous stoechiométrique I2p et à l'oxydation du métal M3 en une couche d'oxyde métallique stoechiométrique I3. A titre d'exemple préféré, le métal M3 est du titane pur qui réagit avec l'oxyde métallique stoechiométrique I2, Ta2O5, pour former l'oxyde métallique stoechiométrique I3, TiO2, et l'oxyde métallique sous stoechiométrique I2p, TaO2. Cette réaction peut selon une possibilité être activée thermiquement.

Avantageusement, la réduction de l'oxyde I2 par le métal M3 est possible si l'enthalpie libre de formation (DG3) de la réaction M3+O2->I3 est supérieure en valeur absolue à l'enthalpie libre de formation (DG2) de la réaction M2+O2->I2. Ceci peut se résumer par | DG3 | > | DG2 |. Un abaque d'Elligham peut typiquement être utilisé afin de prévoir le sens des réactions.

La quantité de métal M3 déposée est très faible au regard de l'épaisseur de I2 de sorte à ne pas consommer l'intégralité de oxyde métallique stoechiométrique I2 sans pouvoir obtenir le profil de déplétion d'oxygène visé dans l'oxyde métallique sous stoechiométrique I2p.

Selon un mode de réalisation le métal M3 réduit la couche d'oxyde métallique stoechiométrique I2, mais pas une couche d'oxyde I1 possiblement présent à la surface de la couche métallique M1. De ce fait il est avantageux que l'enthalpie libre de formation (DG1) de la réaction M1+ O2 -> I1 soit supérieure ou égale en valeur absolue à l'enthalpie libre (DG3) de formation de la réaction M3+O2->I3 c'est-à-dire | DG1 ≥ | DG3| ou | DG1| ≤ | DG(2Cu + O2 -> 2CuO)| c'est-à-dire l'enthalpie libre de formation DG1 de l'oxyde I1 par oxydation d'un métal M1 est supérieure ou égale en valeur absolue à l'enthalpie libre de formation DG de la réaction 2Cu+O2->2CuO.

Une électrode supérieure 3 également appelée « top electrode » en anglais comprend la couche métallique M4 et une couche d'oxyde métallique stoechiométrique I3. La couche d'oxyde métallique I3 forme une couche isolant permettant d'isoler la couche métallique M4 formant partiellement l'électrode supérieure 3 de la couche d'oxyde métallique sous stoechiométrique I2p constituant la couche de réservoir de lacunes d'oxygène. La présence de cette couche isolante I3 permet de s'affranchir d'électrodes nobles ne risquant pas d'être oxydées.

La couche métallique M4 est formée par un métal non noble. On entend par noble, un métal qui ne s'oxyde pas spontanément à l'air. Selon l'invention, les métaux nobles s'entendent de l'argent (Ag), de l'Iridium (Ir), du Platine (Pt), de l'or (Au) et du palladium (Pd). La couche métallique M4 peut être un métal pur ou un alliage métallique binaire ou ternaire tel que par exemple TiN, TaN, TiAlN, TaAlN ou bien encore ou un alliage à base de nitrure, ou de carbure, ou de siliciure, ou d'oxyde métallique conducteur, préférentiellement TiN, TaN.

Selon un mode de réalisation préférée, l'électrode inférieure 1 et l'électrode supérieure 3 sont symétriques. On entend par symétrique que les deux électrodes 1 et 3 sont de même épaisseurs, de même propriétés, de même matériaux.

Selon un exemple préféré, l'empilement de la cellule mémoire se compose de TiN/TiO2/Ta2O5/TaOx/TiO2/TiN, ou TiN/TiO2/Ta2O5/TaOx/Nb2O5/TiN, ou TiN/TiO2/V2O5/VOx/Nb2O5/TiN, ou TiN/TiO2/V2O5/VOx/Ta2O5/TiN

Selon l'invention, un profil en oxygène tel qu'illustré en figure 2 est particulièrement recherché. On peut voir sur cette figure que la couche d'oxyde métallique sous stoechiométrique I2p présente une déplétion en oxygène par rapport aux autres couches d'oxyde métallique stoechiométrique I1, I2 et I3 de l'empilement. On note L_{I2P} l'épaisseur de l'oxyde métallique stoechiométrique I2, et petit I_{I2P} l'épaisseur du profil de déplétion. Le profil de déplétion est caractérisé par I_{I2P}<L_{I2P}.

La présente invention concerne également un procédé de fabrication d'une cellule mémoire telle que décrite ci-dessus.

Un tel procédé comprend un série d'étapes successives dont le dépôt de la couche métallique M1, puis le dépôt de l'oxyde métallique stoechiométrique I2 puis le dépôt d'une couche de métal M3 puis la formation de la couche d'oxyde métallique stoechiométrique I3 et de la couche métallique sous stoechiométrique I2p par réaction entre le métal M3 et l'oxyde stoechiométrique I2, puis le dépôt d'une couche métallique M4.

La réaction entre la couche métallique M3 et l'oxyde métallique stoechiométrique I2 est avantageusement contrôlée par le choix des métaux M1, M2 et M3. Avantageusement, l'enthalpie libre de formation (DG3) de la réaction M3+O2->I3 est supérieure en valeur absolue à l'enthalpie libre de formation (DG2) de la réaction M2+O2->I2. Il est avantageux que l'enthalpie libre de formation (DG1) de la réaction M1+ O2 -> I1 soit supérieure ou égale en valeur absolue à l'enthalpie libre (DG3) de formation de la réaction M3+O2->I3.

Avantageusement, la couche métallique M3 réduit la couche d'oxyde métallique stoechiométrique I2, mais pas une couche d'oxyde stoechiométrique I1 possiblement présent à la surface de la couche métallique M1.

Une cellule mémoire selon l'invention peut être intégrée dans divers dispositif microélectronique allant de dispositifs de stockage de données portables à des structures mémoires neuro-morphiques.

L'intégration des films actifs d'une cellule mémoire selon l'invention telle que décrite ci-dessus, se fait actuellement dans les lignes Back-End des dispositifs microélectroniques utilisant des cellules mémoires, à un niveau métal Mi, l'indice i étant un entier qui représente le nombre de niveaux d'interconnexion dans un dispositif. Ces films sont déposés en planaire à la surface d'un plug. Ensuite, une étape de gravure permet de définir la taille finale de la cellule mémoire. Enfin, un nouveau plug est créé à l'étage supérieur (Mi+1) et vient connecter l'électrode supérieure de la cellule mémoire. La formation d'un plug requiert, le dépôt d'un oxyde à basse température, la gravure d'un trou aligné sur l'électrode supérieure, puis le dépôt dans ce trou d'un métal de contact, typiquement TiN/W ou Ta/TaN/Cu.

Le dépôt de l'oxyde basse température amène de l'oxygène exogène en contact de la cellule mémoire et engendre une détérioration des propriétés de la cellule. On connait du document US2014/0197368 la possibilité de limiter l'impact de l'oxygène exogène amené par l'étape de dépôt de l'oxyde basse température, en déposant un film conforme de SiN par voie CVD après la gravure de l'élément mémoire déposé en planaire Ce film permet de « sceller » les flancs de la cellule mémoire. Ce type de capping à l'oxygène avec SiN est très utilisé pour les transistors CMOS. Toutefois, avec la réduction de taille des dispositifs, ce film de SiN subit aussi une réduction d'épaisseur afin de suivre la géométrie globale des dispositifs. Par exemple dans les lignes des niveaux Mi, l'épaisseur du niveau représente environ 2 à 3 fois la largeur du plug. Ceci afin de respecter un aspect ratio raisonnable pour les plugs afin d'assurer un remplissage optimal des plugs en voie chimique CVD. L'épaisseur minimum du film de SiN proposé dans ce document est de 20nm. Dans le cas où l'élément mémoire présente une taille de l'ordre ou inférieur à 40nm, on s'aperçoit qu'un film de 20nm représente environ 1/3 de la hauteur du niveau Mi. Or, en-dessous d'une certaine épaisseur de SiN d'environ 20nm, le procédé de dépôt plasma de SiO2 impacte les films sous-jacents. Effectivement, le plasma de traitement utilisé in-situ au cours du dépôt de l'isolant inter-plugs est physiquement pénétrant et des espèces de type O* peuvent passer au travers du film de protection en SiN.

Il existe donc le besoin de proposer une technologie qui permet de limiter l'impact de l'oxygène exogène amené par l'étape de dépôt de l'oxyde basse température lors de la formation d'un plug.

Selon un autre aspect de l'invention, la cellule mémoire telle que décrite ci-dessus peut être agencée au moins partiellement dans une cavité 6 aussi dénommée « via ».

Avantageusement, l'invention trouvera également son application pour des dispositifs micro-électroniques et nanoélectroniques comprenant une pluralité de niveaux d'interconnexion et une pluralité de plugs de connexion entre les niveaux. Chaque plug comprend une cavité 6. Selon l'invention, la cavité 6 possède une largeur 8 d'ouverture inférieure à 180nm, préférentiellement égale ou inférieure à 65 nm.

La cavité 6 est formée dans de l'oxyde de SiO2 déposé par voie chimique pour former un plug d'interconnexion débouchant sur une ligne de connexion 7 de niveau inférieure Mi-1. Plus généralement la cavité 6 est formée dans un matériau électriquement isolant.

Selon un premier mode de réalisation illustré aux figures 3 à 7, l'empilement de la cellule mémoire est partiellement agencé dans la cavité 6. La ligne de connexion 7 du niveau inférieur Mi-1 forme la couche métallique M1 et éventuellement sa couche d'oxyde métallique stoechiométrique I1. Cela est possible lorsque la ligne de connexion 7 est en Al, Ta, TaN ou TiN. La couche d'oxyde métallique stoechiométrique I1 est alors en Al2O3, TiO2, TiON, Ta2O5, TaON. La couche métallique M1 de l'électrode inférieure 1 et éventuellement la couche d'oxyde métallique stoechiométrique I1 sont disposées en dehors et sous la cavité. On entend par dessous que la couche métallique M1 est présente avant la formation de la cavité, et on entend par en dehors, que la couche métallique M1 est d'une longueur plus importante que la largeur de la cavité 6.

La cavité 6 comprend de bas en haut, l'isolant 2 comprenant la couche d'oxyde métallique stoechiométrique I2 et la couche d'oxyde métallique sous stoechiométrique I2p formant ladite couche de réservoir de lacunes d'oxygène puis la couche d'oxyde métallique stoechiométrique I3 et la couche métallique M4.

Selon cet empilement, la couche d'oxyde métallique stoechiométrique I1 est avantageusement présente pour maintenir la couche d'oxyde métallique sous-stoechiométrie I2p en contact de couches d'oxyde métallique stoechiométrique I1, I2 et I3.

Selon un deuxième mode de réalisation illustré aux figures 8 et 9, l'empilement de la cellule mémoire est entièrement agencé dans la cavité 6. La ligne de connexion 7 du niveau inférieur Mi-1 ne forme pas la couche métallique M1. Cela est le cas notamment lorsque la ligne de connexion 7 est en un matériau non adapté aux propriétés nécessaires pour former une électrode inférieure 1. La couche métallique M1 de l'électrode inférieure 1 et éventuellement la couche d'oxyde métallique stoechiométrique I1 sont disposées dans la cavité 6. Dans cette réalisation, on note que l'isolant 2 formé au moins par la couche d'oxyde métallique stoechiométrique I2 conforme garantit l'isolation électrique entre les couches métalliques M1 et M4. La couche métallique M1 joue alors le rôle de barrière destinée à limiter la diffusion du matériau de la ligne de connexion 7 dans la cellule mémoire.

Le procédé de fabrication d'une cellule mémoire comprend les étapes décrites ci-après. La formation d'une cavité 6 débouchant sur une ligne de connexion 7 de niveau inférieur Mi-1. Eventuellement, le dépôt conforme d'une couche métallique M1 dans la cavité 6. Eventuellement, le dépôt conforme ou la formation d'une couche d'oxyde métallique stoechiométrique I1 au contact de la couche métallique M1. Le dépôt conforme d'une couche d'oxyde métallique stoechiométrique I2. Avantageusement, le dépôt de la couche d'oxyde métallique stoechiométrique I2 est effectué par dépôt chimique en phase vapeur (acronyme CVD). On entend par dépôt conforme que le dépôt est effectué en fond et sur les parois de la cavité 6. Le dépôt d'une couche de métal M3 en fond de cavité, préférentiellement déposée par dépôt flash physique en phase vapeur (acronyme PVD), par exemple en flash Ti, Al, Zr, Hf, Si, Ta, Nb, V. Le procédé comprend une étape de bouchage de la cavité 6. Au moins une couche métallique M4 est déposée dans la cavité 6. La couche métallique M4 est avantageusement imperméable à l'oxygène tel que par exemple Co, Ni, Cu. Les dépôts des couches métalliques M1 et M4 sont avantageusement réalisés comme pour l'empilement illustré en figure 1.

La réaction de la couche métallique M3 sur l'oxyde métallique stoechiométrique I2 résulte en la formation de l'oxyde sous-stoechiométrique I2p localisé autour, plus précisément à proximité immédiate, de la couche d'oxyde métallique stoechiométrique I3. Cette réaction peut être assistée par recuit typiquement aligné sur le recuit du Back End à environ 400°C. Dans cette réalisation, la couche sensible à l'oxygène exogène I2p se retrouve enterrée en fond de cavité 6, protégée de l'oxydation par des couches isolantes : l'oxyde métallique stoechiométrique I2 résiduel (i.e. n'ayant pas réagi) et l'oxyde métallique stoechiométrique I3 et la couche métallique M4.

Selon l'invention, le procédé comprend une étape de dé-contact des plugs d'un même niveau comprenant un polissage mécano-chimique (acronyme CMP). Lors du dépôt des couches d'oxyde métallique stoechiométrique I2 et métallique M4, de la matière reste potentiellement en dehors de la cavité 6. Cette matière peut entrainer une conduction entre les différentes cavités 6 du niveau dans le dispositif.

Avantageusement, la couche d'oxyde métallique stoechiométrique I2 présente une largeur L comprise entre 2 et 20 nm. Cette largeur L s'entend comme la dimension séparant les parois de la cavité 6 de la couche d'oxyde métallique stoechiométrique I3.

Avantageusement, la couche d'oxyde métallique stoechiométrique I3 présente une largeur l comprise entre 10 et 40 nm, préférentiellement 25nm.

Par exemple, pour une cavité de 45nm, largeur L de la couche d'oxyde métallique stoechiométrique I2 est de 10nm et largeur l de la couche d'oxyde métallique stoechiométrique I3 est de 25nm.

Cette disposition d'empilement permet de de confiner/localiser le filament de lacunes sous la couche d'oxyde métallique stoechiométrique I3 de largeur l. De plus, les lignes de courant sont localisées dans une zone limitée augmentant l'échauffement local. Cette constriction des lignes de courant permet de réduire le potentiel de formation du filament Vf. Le potentiel de formation Vf est avantageusement inférieur à 3V et préférentiellement de l'ordre de 2V autorisant ainsi l'intégration de la cellule mémoire selon l'invention dans des dispositifs CMOS. L'invention présente également l'avantage de réduire la variabilité de l'état passant, Ron, de la cellule mémoire.

Selon une autre possibilité, le bouchage de la cavité peut être réalisé par l'empilement de plusieurs couches. Tel qu'illustré en figures 6 à 9, deux couches métalliques M4 et M5 sont déposées dans la cavité 6 pour la boucher. La couche métallique M4 pouvant être du TiN ou TaN. La couche métallique M5 est un métal imperméable à l'oxygène tel que du Cobalt, du Nickel ou du Cuivre. Dans cette disposition, le procédé de fabrication comprend une étape de déconnection des couches métalliques M1 et M5, avantageusement par CMP.

Cet empilement de la cellule mémoire au moins partiellement dans une cavité peut s'applique au domaine des mémoires CBRam dans lesquelles la modulation de la résistance de l'isolant 2 est réalisée par un filament par exemple de Cuivre dans le cas où la couche métallique M4 est du Cuivre. Ce type de mémoire peut servir à réaliser de structures mémoires du type neuro-morphique.

### REFERENCES

- 1.: Electrode inférieure
- 2.: Isolant
- 3.: Électrode supérieure
- 4.: Filament
- 5.: Lignes de courant
- 6.: Cavité
- 7.: Ligne de connexion
- 8.: Largeur d'ouverture de la cavitéM1. Couche métallique
- I1.: Couche d'oxyde métallique
- I2.: Couche d'oxyde métallique stoechiométrique
- I2p.: Couche d'oxyde métallique sous stoechiométrique
- I3.: Couche d'oxyde métallique stoechiométrique
- M4.: Couche d'oxyde métallique
- L_{I2P}.: Epaisseur finale de la couche d'oxyde sous stoechiométrique I2p
- I_{I2P}.: Epaisseur du profil de déplétion
- l.: Largeur de la couche d'oxyde métallique stoechiométrique I3
- L.: Largeur de la couche d'oxyde métallique stoechiométrique I2

## Revendications

1. Dispositif microélectronique comprenant une cavité (6) dans laquelle est au moins partiellement agencée une cellule mémoire non volatile résistive comprenant un empilement comprenant deux électrodes (1, 3) et un isolant (2) multi-couche, placé entre lesdites deux électrodes (1, 3), l'isolant (2) multi-couche comprenant une couche d'oxyde permettant une transition résistive et une couche de réservoir de lacunes d'oxygène, l'empilement comprenant de bas en haut :
- une électrode inférieure (1) comprenant une couche métallique M1,
- l'isolant (2) comprenant une couche d'oxyde métallique stoechiométrique I2 et une couche d'oxyde métallique sous stoechiométrique I2p formant ladite couche de réservoir de lacunes d'oxygène,
- une électrode supérieure (3) comprenant une couche d'oxyde métallique stoechiométrique I3 disposée en fond de cavité et une couche métallique M4, de sorte que la couche de réservoir de lacunes d'oxygène est intercalée entre deux couches d'oxydes métalliques stoechiométriques I2 et I3.

2. Dispositif microélectronique selon la revendication 1 dans laquelle des métaux M2 et M3 sont choisis de sorte que l'enthalpie libre de formation DG3 de l'oxyde métallique stoechiométrique I3 par oxydation du métal M3 est supérieure en valeur absolue à l'enthalpie libre de formation DG2 de l'oxyde métallique stoechiométrique I2 par oxydation du métal M2.

3. Dispositif microélectronique selon l'une quelconque des revendications précédentes dans laquelle l'électrode inférieure (1) comprend au-dessus de la couche métallique M1, une couche I1 d'oxyde métallique stoechiométrique de M1, et de préférence dans laquelle des métaux M1 et M3 sont choisis de sorte que l'enthalpie libre de formation DG1 de l'oxyde métallique stoechiométrique I1 par oxydation du métal M1 est supérieure ou égale en valeur absolue à l'enthalpie libre de formation DG3 de l'oxyde métallique stoechiométrique I3 par oxydation du métal M3.

4. Dispositif microélectronique selon l'une quelconque des revendications précédentes dans laquelle les couches métalliques M1 et M4 sont formées par au moins un métal parmi un métal non-noble autre que Pd, Ag, Ir, Pt, Au, et de préférence dans laquelle les métaux des couches métalliques M1 et M4 sont un métal pur ou un alliage métallique binaire ou ternaire, ou un alliage à base de nitrure ou de carbure ou de siliciure ou d'oxyde métallique conducteur et de préférence dans laquelle les métaux M1 et M4 sont choisis parmi TiN, TaN, TiAlN, TaAlN.

5. Dispositif microélectronique selon l'une quelconque des revendications précédentes en combinaison de la revendication 3 dans laquelle la couche d'oxyde métallique stoechiométrique I1 de la couche métallique M1 est choisie parmi TiO2 ou TiON ou Al2O3.

6. Dispositif microélectronique selon l'une quelconque des revendications précédentes en combinaison de la revendication 3 dans laquelle la couche d'oxyde stoechiométrique I2 d'un métal M2 est choisi parmi des colonnes III, IV, V, du tableau périodique, ou Al ou Si, ou des lanthanides, et de préférence dans laquelle la couche d'oxyde stoechiométrique I2 est choisie parmi HfO2, ZrO2, TiO2, Al2O3, Ta2O5, Nb2O5, V2O5,La2O4, Gd2O3, Lu2O3, HfSiO, HfZrO, STO.

7. Dispositif microélectronique selon l'une quelconque des revendications précédentes dans laquelle le métal M3 formant la couche d'oxyde métallique I3 est un métal pur ou un alliage métallique binaire ou ternaire, et de préférence dans laquelle le métal M3 est choisi parmi Si, Ti, Zr, Hf, Al, Ta, Nb, V, et les alliages en mélange de ces éléments par exemple TiAl, TaAl.

8. Dispositif microélectronique selon l'une quelconque des revendications précédentes dans laquelle l'empilement comprend de bas en haut : TiN/TiO2/Ta2O5/TaOx/TiO2/TiN.

9. Dispositif selon l'une quelconque des revendications précédentes dans laquelle l'électrode inférieure (1) de la cellule mémoire est agencée en dessous et en dehors de la cavité (6) ou dans laquelle l'électrode inférieure (1) de la cellule mémoire est agencée dans la cavité (6) et dans laquelle la couche d'oxyde stoechiométrique I2 présente de préférence une épaisseur de 1 à 50nm.

10. Dispositif selon l'une quelconque des revendications précédentes comprenant une pluralité de niveau d'interconnexion et une pluralité de plug de connexion entre les niveaux, chaque plug comprenant une cavité (6) dans laquelle est au moins partiellement agencée la cellule mémoire.

11. Procédé de fabrication d'un dispositif microélectronique selon l'une quelconque des revendications précédentes comprenant les étapes successives suivantes :
- Dépôt d'une couche métallique M1 pour former l'électrode inférieure (1),
- Dépôt d'une couche d'oxyde métallique stoechiométrique I2,
- Dépôt d'une couche métallique M3,
- Réaction de la couche métallique M3 avec l'oxyde métallique stoechiométrique I2 formant un oxyde sous stoechiométrique I2p et un oxyde métallique stoechiométrique I3,
- Dépôt d'une couche métallique M4.

12. Procédé selon la revendication précédente dans lequel le dépôt de la couche métallique M3 est réalisé par dépôt flash en phase vapeur et dans lequel la couche métallique M3 est déposée de préférence sur une épaisseur de 0,1 à 2 nm.

13. Procédé selon l'une quelconque des deux revendications précédentes dans lequel la couche d'oxyde métallique stoechiométrique I2 est déposée par voie chimique et de préférence dans lequel la couche d'oxyde métallique stoechiométrique I2 est traitée au plasma ou par nitruration plasma.

14. Procédé selon l'une quelconque des trois revendications précédentes dans lequel la couche d'oxyde métallique stoechiométrique I2 est implantée d'aluminium.

15. Procédé de fabrication d'un dispositif selon l'une quelconque des revendications 1 à 10, comprenant les étapes successives suivantes :
- Dépôt conforme d'une couche d'oxyde métallique stoechiométrique I2 dans la cavité (6),
- Dépôt d'une couche métallique M3 dans la cavité (6),
- Réaction de la couche métallique M3 avec l'oxyde métallique stoechiométrique I2 formant un oxyde sous stoechiométrique I2p et un oxyde métallique stoechiométrique I3,
- Dépôt d'au moins une couche métallique M4 dans la cavité (6) ;
et, de préférence, comprenant avant l'étape de dépôt de la couche d'oxyde métallique stoechiométrique I2, une étape de dépôt conforme d'une couche métallique M1 dans la cavité (6) pour former l'électrode inférieure (1).

16. Procédé selon la revendication précédente dans lequel le dépôt de couche métallique M3 n'est pas conforme.

## Patentansprüche

1. Mikroelektronische Vorrichtung mit einem Hohlraum (6), in dem wenigstens teilweise eine resistive, nichtflüchtige Speicherzelle angeordnet ist, enthaltend eine Stapelung aus zwei Elektroden (1, 3) und einem zwischen den beiden Elektroden (1, 3) angeordneten mehrschichtigen Isolator (2), wobei der mehrschichtige Isolator (2) eine Oxidschicht, die einen resistiven Übergang gestattet, und eine Reservoirschicht für Sauerstoffleerstellen aufweist,
- wobei die Stapelung von unten nach oben enthält:
- eine untere Elektrode (1) mit einer Metallschicht M1,
- wobei der Isolator (2) eine stöchiometrische Metalloxidschicht I2 und eine unterstöchiometrische Metalloxidschicht I2p umfasst, die die Reservoirschicht für Sauerstoffleerstellen bildet,
- eine obere Elektrode (3), die eine am Boden des Hohlraums angeordnete stöchiometrische Metalloxidschicht I3 und eine Metallschicht M4 umfasst, so dass die Sauerstoffleerstellen-Reservoirschicht zwischen zwei stöchiometrischen Metalloxidschichten I2 und I3 eingefügt ist.

2. Mikroelektronische Vorrichtung nach Anspruch 1, wobei die Metalle M2 und M3 so ausgewählt sind, dass die frei Bildungsenthalpie DG3 des stöchiometrischen Metalloxids I3 durch Oxidation des Metalls M3 im Absolutwert größer ist als die freie Bildungsenthalpie DG2 des stöchiometrischen Metalloxids I2 durch Oxidation des Metalls M2.

3. Mikroelektronische Vorrichtung nach einem der vorangehenden Ansprüche, wobei die untere Elektrode (1) über der Metallschicht M1 eine Schicht I1 aus stöchiometrischem Metalloxid M1 enthält, wobei vorzugsweise die Metalle M1 und M23 so ausgewählt sind, dass die freie Bildungsenthalpie DG1 des stöchiometrischen Metalloxids I1 durch Oxidation des Metalls M1 im Absolutwert größer oder gleich der freien Bildungsenthalpie DG3 des stöchiometrischen Metalloxids I3 durch Oxidation des Metalls M3 ist.

4. Mikroelektronische Vorrichtung nach einem der vorangehenden Ansprüche, wobei die Metallschichten M1 und M4 aus zumindest einem Metall aus einem anderen Nicht-Edelmetall als Pb, Ag, Ir, Pt, Au gebildet sind, und wobei vorzugsweise die Metalle der Metallschichten M1 und M3 ein reines Metall oder eine binäre oder ternäre Metalllegierung oder eine Legierung auf Basis von Nitrid oder Carbid oder Silicid oder leitfähigem Metalloxid sind und wobei vorzugsweise die Metalle M1 und M4 ausgewählt sind aus TiN, TaN, TiAlN, TaAlN.

5. Mikroelektronische Vorrichtung nach einem der vorangehenden Ansprüche in Kombination mit Anspruch 3, wobei die stöchiometrische Metalloxidschicht I1 der Metallschicht M1 ausgewählt ist aus TiO2 oder TiON oder Al2O3.

6. Mikroelektronische Vorrichtung nach einem der vorangehenden Ansprüche in Kombination mit Anspruch 3, wobei die stöchiometrische Metalloxidschicht I2 aus einem Metall M2 ausgewählt ist aus den Spalten III, IV, V des Periodensystems, oder aus Al oder Si oder aus Lanthaniden, wobei vorzugsweise die stöchiometrische Oxidschicht I2 ausgewählt ist aus HfO2, ZrO2, TiO2, Al2O3, Ta2O5, Nb2O5, V2O5, La2O4, Gd2O3, Lu2O3, HfSiO, HfZrO, STO.

7. Mikroelektronische Vorrichtung nach einem der vorangehenden Ansprüche, wobei das Metall M3, das die Metalloxidschicht I3 bildet, ein reines Metall oder eine binäre oder ternäre Metalllegierung ist, wobei vorzugsweise das Metall M3 ausgewählt ist aus Si, Ti, Zr, Hf, Al, Ta, Nb, V und den Mischlegierungen dieser Elemente, beispielsweise TiAl, TaAl.

8. Mikroelektronische Vorrichtung nach einem der vorangehenden Ansprüche, wobei die Stapelung von unten nach oben enthält: TiN/TiO2/Ta2O5/TaOx/TiO2/TiN.

9. Vorrichtung nach einem der vorangehenden Ansprüche, wobei die untere Elektrode (1) der Speicherzelle unterhalb und außerhalb des Hohlraums (6) angeordnet ist oder wobei die untere Elektrode (1) der Speicherzelle in dem Hohlraum (6) angeordnet ist und wobei die stöchiometrische Oxidschicht I2 vorzugsweise eine Dicke von 1 bis 50 nm aufweist.

10. Vorrichtung nach einem der vorangehenden Ansprüche, enthaltend eine Mehrzahl von Zwischenverbindungsebenen und eine Mehrzahl von Verbindungsplugs zwischen den Ebenen, wobei jeder Plug einen Hohlraum (6) aufweist, in welchem zumindest teilweise die Speicherzelle angeordnet ist.

11. Verfahren zum Herstellen einer mikroelektronischen Vorrichtung nach einem der vorangehenden Ansprüche, umfassend die nachstehenden, aufeinanderfolgenden Schritte:
- Abscheiden einer Metallschicht M1 zum Bilden der unteren Elektrode (1),
- Abscheiden einer stöchiometrischen Metalloxidschicht I2,
- Abscheiden einer Metallschicht M3,
- Reaktion der Metallschicht M3 mit der stöchiometrischen Metalloxidschicht I2, die ein unterstöchiometrisches Oxid I2P und ein stöchiometrisches Metalloxid I3 bildet,
- Abscheiden einer Metallschicht M4.

12. Verfahren nach dem vorangehenden Anspruch, wobei das Abscheiden der Metallschicht M3 durch Flash-Dampfabscheidung erfolgt und wobei die Metallschicht M3 vorzugsweise über eine Dicke von 0,1 bis 2 nm abgeschieden wird.

13. Verfahren nach einem der beiden vorangehenden Ansprüche, wobei die stöchiometrische Metalloxidschicht I2 chemisch abgeschieden wird und wobei vorzugsweise die stöchiometrische Metalloxidschicht I2 mit Plasma oder durch Plasmanitrieren behandelt wird.

14. Verfahren nach einem der drei vorangehenden Ansprüche, wobei die stöchiometrische Metalloxidschicht I2 mit Aluminium implantiert wird.

15. Verfahren zum Herstellen einer Vorrichtung nach einem der Ansprüche 1 bis 10, umfassend die nachstehenden, aufeinanderfolgenden Schritte:
- konformes Abscheiden einer stöchiometrischen Metalloxidschicht I2 in den Hohlraum (6),
- Abscheiden einer Metallschicht M3 in den Hohlraum (6),
- Reaktion der Metallschicht M3 mit dem stöchiometrische Metalloxid I2, das ein unterstöchiometrisches Oxid I2P und ein stöchiometrisches Metalloxid I3 bildet,
- Abscheiden zumindest einer Metallschicht M4 in den Hohlraum (6);
und vorzugsweise umfassend vor dem Schritt des Abscheidens der stöchiometrischen Metalloxidschicht I2 einen Schritt des konformen Abscheidens einer Metallschicht M1 in den Hohlraum (6), um die untere Elektrode (1) zu bilden.

16. Verfahren nach dem vorangehenden Anspruch, wobei die Abscheidung der Metallschicht M3 nicht konform ist.

## Claims

1. Microelectronic device comprising a cavity (6) in which a resistive non-volatile memory cell is at least partially arranged, said cell comprising a stack comprising two electrodes (1, 3) and a multilayer insulant (2), placed between said two electrodes (1, 3), the multilayer insulant (2) comprising a layer of oxide allowing a resistive transition and an oxygen vacancy reservoir layer, the stack comprising, from bottom to top:
- a lower electrode (1) comprising a metal layer M1,
- the insulant (2) comprising a layer of stoichiometric metal oxide I2 and a layer of sub-stoichiometric metal oxide I2p forming said oxygen vacancy reservoir layer,
- an upper electrode (3) comprising a layer of stoichiometric metal oxide I3 positioned at the cavity bottom and a metal layer M4, in such a way that the oxygen vacancy reservoir layer is interspaced between two layers of stoichiometric metal oxides I2 and I3.

2. Microelectronic device according to claim 1 in which metals M2 and M3 are chosen in such a way that the absolute value of the free enthalpy of formation DG3 of the stoichiometric metal oxide I3 via oxidation of the metal M3 is greater than the absolute value of the free enthalpy of formation DG2 of the stoichiometric metal oxide I2 via oxidation of the metal M2.

3. Microelectronic device according to any one of the previous claims in which the lower electrode (1) comprises, above the metal layer M1, a layer I1 of stoichiometric metal oxide of M1, and preferably in which metals M1 and M3 are chosen in such a way that the absolute value of the free enthalpy of formation DG1 of the stoichiometric metal oxide I1 via oxidation of the metal M1 is greater than or equal to the absolute value of the free enthalpy of formation DG3 of the stoichiometric metal oxide I3 via oxidation of the metal M3.

4. Microelectronic device according to any one of the previous claims in which the metal layers M1 and M4 are formed by at least one metal out of a non-noble metal other than Pd, Ag, Ir, Pt, Au, and preferably in which the metals of the metal layers M1 and M4 are a pure metal or a binary or ternary metal alloy, or an alloy containing nitride or carbide or silicide or conductive metal oxide and preferably in which the metals M1 and M4 are chosen from TiN, TaN TiAlN, TaAlN.

5. Microelectronic device according to any one of the previous claims in combination of claim 3 in which the layer of stoichiometric metal oxide I1 of the metal layer M1 is chosen from TiO2 or TiON or Al2O3.

6. Microelectronic device according to any one of the previous claims in combination of claim 3 in which the layer of stoichiometric oxide I2 of a metal M2 is chosen out of columns III, IV, V, of the periodic table, or Al or Si, or lanthanides, and preferably in which the layer of stoichiometric oxide I2 is chosen from Hf02, Zr02, Ti02, Al2O3, Ta2O5, Nb2O5, V2O5,La2O4, Gd2O3, Lu2O3, HfSiO, HfZrO, STO.

7. Microelectronic device according to any one of the previous claims in which the metal M3 forming the layer of metal oxide I3 is a pure metal or a binary or ternary metal alloy, and preferably in which the metal M3 is chosen from Si, Ti, Zr, Hf, Al, Ta, Nb, V, and the alloys of mixtures of these elements for example TiAl, TaAl.

8. Microelectronic device according to any one of the previous claims in which the stack comprises, from bottom to top: TiN/TiO2/Ta2O5/TaOx/TiO2/TiN.

9. Device according to any one of the previous claims in which the lower electrode (1) of the memory cell is arranged below and outside of the cavity (6) or in which the lower electrode (1) of the memory cell is arranged in the cavity (6) and in which the layer of stoichiometric oxide I2 preferably has a thickness of 1 to 50nm.

10. Device according to any one of the previous claims, comprising a plurality of interconnection level and a plurality of connection plug between the levels, each plug comprising a cavity (6) in which the memory cell is at least partially arranged.

11. Method for manufacturing a microelectronic device according to any one of the previous claims, comprising the following successive steps:
- Deposition of a metal layer M1 in order to form the lower electrode (1),
- Deposition of a layer of stoichiometric metal oxide I2,
- Deposition of a metal layer M3,
- Reaction of the metal layer M3 with the stoichiometric metal oxide I2 forming a sub-stoichiometric oxide I2p and a stoichiometric metal oxide I3,
- Deposition of a metal layer M4.

12. Method according to the previous claim, wherein the deposition of the metal layer M3 is carried out via flash vapour phase deposition and wherein the metal layer M3 is preferably deposited over a thickness of 0.1 to 2nm.

13. Method according to any one of the previous two claims, wherein the layer of stoichiometric metal oxide I2 is deposited chemically and preferably wherein the layer of stoichiometric metal oxide I2 is treated with plasma or via plasma nitriding.

14. Method according to any one of the previous three claims, wherein the layer of stoichiometric metal oxide I2 is implanted with aluminium.

15. Method for manufacturing a device according to any one of claims 1 to 10, comprising the following successive steps:
- Conformal deposition of a layer of stoichiometric metal oxide I2 in the cavity (6),
- Deposition of a metal layer M3 in the cavity (6),
- Reaction of the metal layer M3 with the stoichiometric metal oxide I2 forming a sub-stoichiometric oxide I2p and a stoichiometric metal oxide I3,
- Deposition of at least one metal layer M4 in the cavity (6);
and preferably comprising, before the step of deposition of the layer of stoichiometric metal oxide I2, a step of conformal deposition of a metal layer M1 in the cavity (6) in order to form the lower electrode (1).

16. Method according to the previous claim, wherein the deposition of the metal layer M3 is not conformal.
